# EUROPEAN PATENT SPECIFICATION

(11) **EP 3 756 226 B1**
(45) Date of publication and mention of the grant of the patent: **27.10.2021**
(21) Application number: 19712686.5
(22) Date of filing: 14.02.2019
(51) Int. Cl.: H01L 33/00, H01L 33/56

(54) **SEALED DEVICE WITH LIGHT ENGINE**
ABGEDICHTETE VORRICHTUNG MIT LICHTMASCHINE
DISPOSITIF ÉTANCHE DOTÉ D'UN MOTEUR LUMIÈRE

(30) Priority: 19.02.2018 EP 18157471
(43) Date of publication of application: 30.12.2020
(73) Proprietor: Signify Holding B.V., 5656 AE Eindhoven (NL)
(72) Inventor: JANSSEN, Merlijn, Antonius, Petrus, Maria, 5656 AE Eindhoven (NL)
(74) Representative: Verweij, Petronella Daniëlle
(86) International application number: PCT/EP2019/053684
(87) International publication number: WO 2019/158648

(56) References cited:
- WO-A1-2011/132805
- JP-A- H0 883 869
- US-A1- 2012 299 017
- US-A1- 2015 097 206
- US-A1- 2016 126 430
- US-B1- 6 635 363

## Description

### FIELD OF THE INVENTION

The present invention relates to a device comprising a housing including a light engine, said housing being fitted in or on a part of the device; and an elastomer moulding over said housing, said elastomer moulding comprising a central region acting as a light exit window for light emitted by said light engine and a peripheral region around said central region, said peripheral region contacting said part and acting as a seal.

The present invention further relates to a method of sealing such a device with such an elastomer.

### BACKGROUND OF THE INVENTION

Nowadays, many devices, e.g. electronic devices such as domestic appliances, portable electronic devices such as smart phones, tablets, and so on, or lighting devices, include one or more light engines such as light-emitting diodes (LEDs). Such light engines may be used to provide functional or aesthetic illumination of a target area or may be used as indicators of the device, for example to indicate a functional mode of the device, an error occurring within the device, the end of life of a component within the device, and so on.

The light engine typically is fitted in its own component or housing, which is assembled into the device in any suitable manner. This typically leads to different parts of the device, i.e. the housing and another part, contacting each other. Such contact areas typically have to be sealed in order to make the contact area water-resistant or water-proof, which may be achieved by overmoulding the housing with an elastomer such as for example silicone. An example of suitable elastomers for such moulding purposes can be found in US 8,674,038 B2.

US-2010/163909 discloses an LED device comprising a housing including an LED chip, an inner protective layer covering the LED chip and its wire connecting points, and an outer protective layer covering the inner protective layer. Each of the inner and outer protective layers is made of silicone, epoxy, or a hybrid compound thereof, but the inner protective layer has a greater hardness than the outer protective layer. WO-2011/057831 discloses a method to manufacture an LED device, comprising the steps of mounting an LED chip onto a surface of a substrate, depositing a transparent base layer to cover the substrate surface and the LED, and dispensing a matrix material to form a half-spherical cover covering the LED and nearby portions of the base layer. Each of the base layer and the cover layer may be made from a two-component silicone resin. With a heat treatment, the cover layer is hardened to become harder than the base layer.

US-2016/0126430 discloses an LED device comprising a housing including an LED chip, an inner protective layer covering the LED chip, and an outer protective layer covering the inner protective layer, wherein the outer protective layer has a greater hardness than the inner protective layer, and wherein the inner and outer protective layers may differ in composition and/or curing profile.

JP-H08083869 discloses an LED device comprising an LED chip mounted on a surface of a substrate, and an elastomer moulding covering the LED chip, wherein the elastomer moulding comprises a central region acting as a light exit window for light emitted by the LED chip and a peripheral region around the central region, wherein the peripheral region contacts the surface of the substrate and acts as a seal, and wherein the central region has a greater hardness than the peripheral region.

A problem with elastomers is that due to their electrically non-conductive nature, they become statically charged such that they attract dust particles. This can deteriorate the appearance and/or performance of the light engine covered by the central region of the elastomer moulding, giving the light engine a matt appearance and reducing the transparency of the moulding, for instance. Attempts to clean the elastomer moulding can lead to such dust particles scratching or being pressed into to the central region of the elastomer moulding acting as the light exit window of the light engine, which makes such deterioration permanent.

### SUMMARY OF THE INVENTION

The present invention seeks to provide a device comprising a housing including a light engine, said housing being fitted in or on a part of the device; and an elastomer moulding over said housing that combines a flexible seal with a scratch-resistant central region of its elastomer moulding.

The present invention further seeks to provide a method of sealing such a device with such an elastomer seal.

According to an aspect, there is provided a device comprising a housing including a light engine, said housing contacting a part of the device; and an elastomer moulding over said housing, said elastomer moulding comprising a central region acting as a light exit window for light emitted by said light engine and a peripheral region around said central region, said peripheral region contacting said part and acting as a seal; wherein the central region is cured and the peripheral region is not cured or cured to a lesser degree than the central region so that said central region has a greater hardness than said peripheral region.

The present invention is based on the realization that the hardness of many elastomers may be tuned, for example through curing. In the context of the present application, curing may refer to the process of cross-linking as well as to the process of polymerization, e.g. through irradiation with actinic radiation having a wavelength that induces such a curing reaction. Therefore, by selectively curing only the central region, i.e. the light exit window, of the elastomer moulding, the central region is hardened and becomes more scratch resistant as a result, whilst the peripheral region of the elastomer moulding retains its softness and pliability that ensures the sealing of the device by the moulding. The central region is cured and the peripheral region is not cured to achieve the difference in hardness between the central region and the peripheral region.

In the context of the present application, where reference is made to hardness, it should be understood that this does not necessarily refer to a particular hardness scale but rather refers to the relative hardness of the central region to the peripheral region. This may be quantified in any suitable manner, e.g. using the respective Young's moduli of the central region and the peripheral region or the Shore A or Shore D hardness of these regions.

The light exit window portion of the elastomer moulding, i.e. its central region, may perform an optical function, e.g. may act as a lens, diffuser or light guide, as will be understood by the skilled person.

In an embodiment, at least part of the light emitted by the light engine has a wavelength capable of curing said central portion. This has the advantage that no separate curing step is necessary during the sealing of the device in order to increase the scratch resistance of the central region of the elastomer moulding, thereby simplifying the sealing process. For example, the light engine may comprise a light emitting diode capable of emitting UV radiation in order to effect such selective curing of the central region, as the peripheral region lies outside the light exit window and is therefore not exposed to such UV radiation.

The light emitting diode capable of emitting UV radiation may be the primary light engine of the device. Alternatively, the housing may further comprise a further LED capable of emitting visible light, in which case the UV emitting LED may be added to the housing for the sole or primary purpose of curing the elastomer. The first LED and the second LED may together form a first light engine or they may form a first light engine and a second light engine. The first LED and the second LED may be located on the same carrier, for example, a printed circuit board (PCB) or they may be located on separate carriers.

Any suitable curable elastomer may be used as the moulding of the device. In a preferred embodiment, the elastomer is silicone, as silicone has excellent pliability, which makes its particularly suitable as a sealant, whilst also having excellent transparency, which makes it particularly suitable as a light exit window material. A particularly suitable silicone polymer is polydimethylsiloxane although other types of silicone polymers or indeed non-silicone polymers such as PTFE (polytetrafluoroethylene) may also be contemplated.

The device in which the housing with the light engine is integrated is not particularly limited, and may any type of device, for example a device that may be exposed to an environment in which moisture or water is present such that the peripheral portion of the elastomer protects the device from ingress of such moisture or water. In at least some embodiments, the device is an electronic device such as a domestic appliance, e.g. a refrigerator, freezer, microwave oven, water purifier, dehumidifier, vacuum cleaner, blender, cooker, food processor, mixer, and so on, or a portable electronic device, e.g. a smart phone, tablet computer, laptop computer and so on.

In accordance with another aspect, there is provided a method of sealing a device comprising a housing including a light engine, said housing contacting a part of the device, the method comprising providing an elastomer moulding over said housing such that the elastomer comprises a central region acting as a light exit window for light emitted by said light engine and a peripheral region around said central region, said peripheral region contacting said part and acting as a seal; and selectively curing the central region of the elastomer such that said central region has a greater hardness than said peripheral region. In this manner, a moulded or overmoulded device is provided in a simple and straightforward manner in which the scratch resistance of its light exit window is improved without compromising the desired flexibility of its seal. The housing may be moulded as a separate item and then fitted to the light engine. It may partially or completely encompass the light engine and it may partially or completely encompass other components of the system such as LED driver components. The housing may house a carrier such as a printed circuit board (PCB) for example onto which the light engine is mounted together with one or more electrical components such as a driver for the light engine. The one or more components may be mounted on the front side of the PCB, the backside of the PCB or a combination of both.

In other embodiments, the carrier and associated components may be overmoulded, this may be achieved by insert loading the completed carrier into a mould and then injecting or pouring the elastomer into the mould.

In one set of embodiments, selectively curing comprises selectively irradiating said central region with a light source external to said device through a mask. This for example is advantageous when the light engine itself cannot provide the actinic radiation with the appropriate wavelength to induce the curing of the light exit window, e.g. in a scenario in which the light engine comprises one or more LEDs emitting visible light only.

Alternatively, selectively curing comprises selectively irradiating said central region with the light engine. This for example is advantageous when the light engine itself can provide the actinic radiation with the appropriate wavelength to induce the curing of the light exit window such that no external light source is required to provide this radiation. This also avoids the need to manufacture and provide a mask for the selective irradiation of the light exit window, as the surrounding seal region cannot be (directly) exposed to the actinic radiation produced by the light engine.

The selectively irradiating of said central region may comprise selectively irradiating the central region with UV radiation, as UV radiation is capable of curing many types of elastomers.

Preferably, the elastomer is a silicone such as polydimethylsiloxane for the reasons already explained above.

### BRIEF DESCRIPTION OF THE DRAWINGS

Embodiments of the invention are described in more detail and by way of non-limiting examples with reference to the accompanying drawings, wherein:
Figs. 1-3 schematically depict a moulded device and its moulding method in accordance with an embodiment of the present invention;
Figs. 4 and 5 schematically depict a moulded device and its moulding method in accordance with another embodiment of the present invention; and
Fig. 6 schematically depicts a moulded device in accordance with yet another embodiment of the present invention.

### DETAILED DESCRIPTION OF THE EMBODIMENTS

It should be understood that the Figures are merely schematic and are not drawn to scale. It should also be understood that the same reference numerals are used throughout the Figures to indicate the same or similar parts.

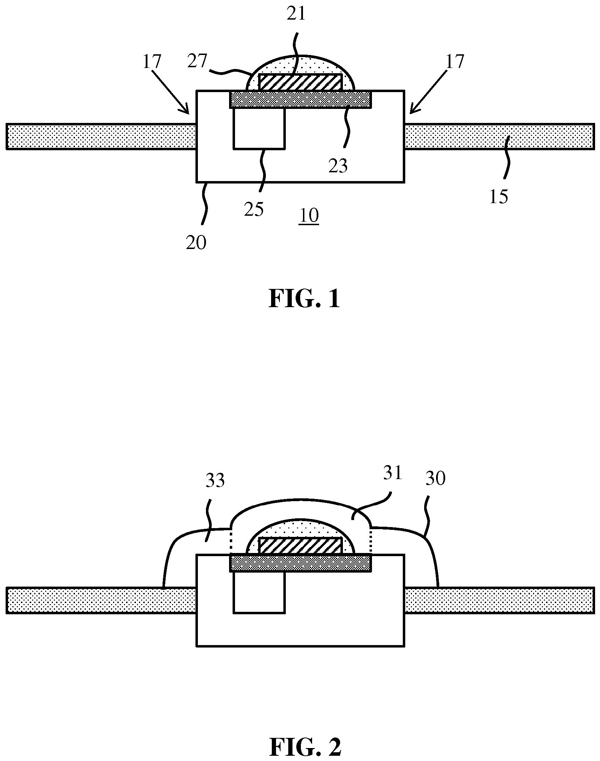

Fig. 1 schematically depicts a device 10 according to an embodiment of the present invention and its method of providing a moulding on the device 10. As shown in Fig. 1, the device 10 has a part 15 comprising a housing 20 that houses a light engine 21. The housing 20 typically is a separate module that is assembled into the device 10 in any suitable manner. By way of non-limiting example, it is shown in the figure that the housing 20 is slotted into an aperture within the part 15 but it should be understood that the way the housing 20 is assembled into the part 15 is not of critical importance to the present invention.

The housing 20 may be assembled into the device 10 in any suitable manner. Similarly, the part 15 may be any suitable part of the device 10, such as a device housing, a carrier, and so on, which may be made of any suitable material. Again, the teachings of the present invention are by no means limited to any particular embodiment of such a part 15, the part 15 may have any suitable form or shape.

The lighting module embodied by the housing 20 equally may have any suitable shape or form. As shown in Fig. 1 by way of non-limiting example, the housing 20 may house a carrier 23 such as a PCB for example onto which the light engine 21 is mounted together with one or more electrical components 25 such as a driver for the light engine 21. The PCB (printed circuit board) may be a metal core PCB (MCPCB) or a glass-reinforced epoxy laminate (FR4) or any other suitable substrate. In at least some embodiments, the light engine 21 comprises at least one LED, which may be any suitable type of LED or combination of LEDs adapted to produce a luminous output having any desirable spectral composition. Where the light engine 21 comprises a plurality of LEDs, each of the LEDs may produce a luminous output having the same spectral composition or different LEDs may produce a luminous output having different spectral compositions. The LEDs may be addressed together as a single light engine or may be individually addressable. In order to electrically insulate the light engine 21, an electrically insulating cover 27 may be formed over the light engine 21. Such an electrically insulating cover 27 may take any suitable shape, such as a glass or polymer cover plate, an electrically insulating polymer moulding, and so on. The electrically insulating cover 27 may provide an optical function, e.g. may act as a lens, diffuser or the like in order to shape the luminous output of the light engine 21. As such lighting modules are well-known per se, many other variations to the design of such a lighting module will be immediately apparent to the skilled person and it should be understood that embodiments of the present invention are not limited to a particular design of the lighting module.

Where the housing 20 contacts the part 15, i.e. the contact area 17 as indicated by the arrows in Fig. 1, the contact area 17 typically is not water resistant, that is to say, moisture or water can penetrate the device 10 through the contact area 17, for example through fixing holes in the part 15 where the housing 20 is affixed to the part 15, through a narrow gap between the part 15 and the housing 20 where an aperture is present in the part 15 into which the housing is slotted, and so on. This generally is unwanted as the device 10 typically houses electrical components, which would become exposed to such moisture or water ingress and could cause short-circuits or electrical component failure, leading to the failure of the device 10.

For this reason, as shown in Fig. 2, a moulding 30 may be provided over the housing 20, which contacts the edge 15 in order to provide a water-resistant or water-tight seal around the housing 20 in order to prevent such ingress of moisture or water into the device 10. Such a moulding 30 may be applied in any suitable manner. The material of the moulding 30 typically is an elastomer, which may contain a solvent to increase its pliability such that the moulding 30 may be effectively applied to the device 10 in order to seal the contact area 17, with the moulding 30 subsequently hardening by evaporation of the solvent although preferably the moulding 30 remains pliable (soft) in order to preserve the seal around the housing 20 upon a stress being applied to the seal 30, e.g. because of movement in the part 15, movement of the housing 20 relative to the part 15, and so on. In a preferred embodiment, the elastomer is a silicone such as PDMS or another suitable type of silicone although it should be understood that embodiments of the present invention are not necessarily limited to silicone-based elastomers; any elastomer that can be used to seal the contact area 17 and is sufficiently transparent to act as a light exit window for the light engine 21 may be contemplated. As an alternative to silicone, PTFE is mentioned by way of non-limiting example, as many other suitable elastomers will be immediately apparent to the skilled person. However, silicone is preferred due to its excellent flexibility and transparency after application of the moulding 30.

This remaining pliability or softness of the elastomer however may cause problems for the function to be delivered by the light engine 21. This is because the moulding 30 performs two functions; a central region 31 of the moulding 30 acts as the light exit window for the light engine 21, whereas a peripheral region 33 of the moulding 30 surrounding the central region 31 acts as the seal for the contact area 17 as explained above. Particularly, as the elastomer, e.g. silicone, is electrically insulating, static charges may accumulate on the outer surface of the moulding 30, which attracts dust particles onto this outer surface. Upon the attempted removal of such dust particles, such dust particles may become embedded into the moulding 30 or may scratch the outer surface of the moulding, which is particularly undesirable in the central region 31. This compromises the performance of the central region 31 as a light exit window. This may be due to the dust and scratches imparting to the light exit window a matte appearance and subsequently reducing its transparency. At this point it is noted that the central region 31 of the moulding 30 may also perform an optical function, e.g. a lens function, light guide function or the like for the light engine 21, in which case the optical function may also be compromised by the ingress of dust particles into the central region 31 or damage caused by such dust particles to the central region 31 of the moulding 30. It is furthermore noted that the peripheral region 33 of the moulding 30 may have any suitable geometry, such as a contact surface of the part 15, it may wrap around the part 15, and so on. This is not an essential part of the present invention. As will be readily understood by the skilled person, the moulding 30 may be an overmoulding in some embodiments.

The present invention is based on the knowledge that the properties of such elastomers, e.g. silicone, can be altered by invoking a curing reaction in the elastomer. This typically causes a hardening of the elastomer, making the cured elastomer brittle and glassy. This is typically unwanted because the seal function to be performed by the peripheral region 33 of the moulding 30 is typically lost or at least severely compromised if the moulding 30 is hardened in this manner, as the moulding 30 loses the required flexibility in order to maintain the seal upon movement of the part 15 and/or the housing 20.

The insight of the present invention is that if only the central region 31 of the moulding 30 is cured in this manner, only the hardness of only the central region 31 is increased, whilst the peripheral region 33 acting as the seal retains the desired softness.

This means that the central region becomes harder than the peripheral region 33, i.e. the peripheral region 33 remains uncured or cured to a lesser degree than the central region 31. Consequently, the scratch resistance of the central region 31 of the moulding 30 is improved as the more glassy nature of the cured central region 31 improves its scratch resistance and reduces the risk of dust particles being pressed into the hardened central region 31 when cleaning the light exit window formed by the central region 31.

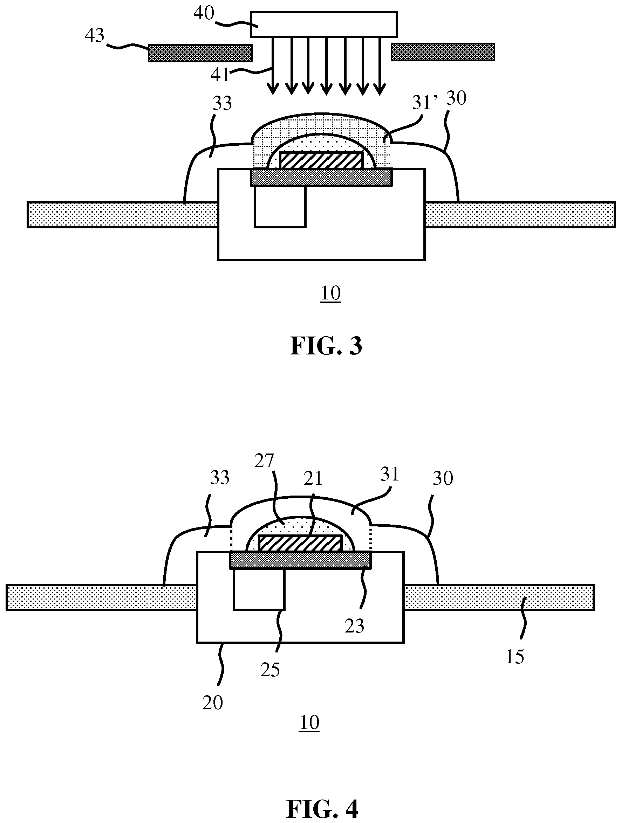

Fig. 3 shows an embodiment wherein the central region 31 of the moulding 30 is selectively hardened through exposure of the central region 31 to actinic radiation 41 of a suitable wavelength as produced by an external light source 40 through a mask 43. The mask 43 ensures that only the central region 31 of the moulding 30 is exposed to the actinic radiation 41 whilst the peripheral region 33 of the moulding 30 is protected from exposure to the actinic radiation 41. The actinic radiation 41 initiates a curing reaction within the elastomer portion of the moulding 30 forming the central region 31, which hardens the central region 31 and converts it into hardened central region 31' as schematically depicted in Fig. 3.

At least a portion of the spectral composition of the actinic radiation 41 may lie in the UV part of the electromagnetic spectrum. For example, where the elastomer forming the moulding 30 is silicone, the actinic radiation may comprise or consist of UV radiation such as UV-C radiation having a wavelength of 254 nm. Of cause, the actinic radiation 41 may have any suitable spectral composition in order to invoke such a curing reaction depending on the chemical composition of the elastomer forming the moulding 30. The external light source 40 and mask 43 may be integrated into an apparatus into which the device 10 may be positioned in order to perform the curing reaction of the central region 31 of the moulding 30. Such an apparatus may comprise a feeder belt or the like onto which multiple devices 10 can be positioned such that the hardening of the central region 31 may be performed in an automated manner by feeding each device 10 into the apparatus and performing the curing reaction of the central region 31 whilst the device 10 is correctly positioned within the apparatus.

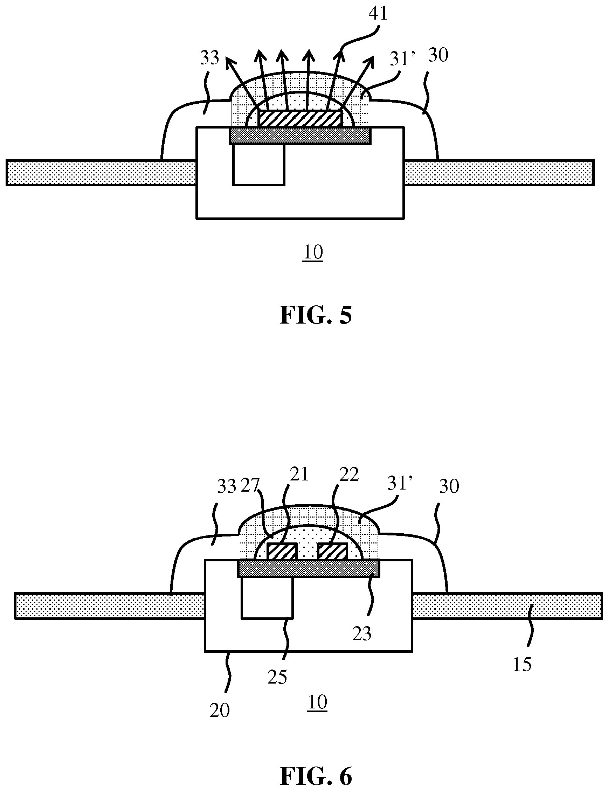

In another embodiment, which is schematically depicted in Fig. 4, the light engine 21 is capable of generating the actinic radiation 41 comprising the spectral component, e.g. a UV component, for hardening the central region 31 of the moulding 30. For example, the light engine 21 may comprise a UV LED. In such a scenario, after the moulding 30 has been applied over the housing 20 to seal the contact area between the housing 20 and the part 15 of the device 10 as schematically depicted in Fig. 4, the light engine 21 may be switched on as shown in Fig. 5 to produce the actinic radiation 41 and convert the central region 31 into hardened central region 31'. This has an advantage that no external light source 40 and mask 43 have to be provided, which may simplify the manufacturing process of the device 10 wherein the device 10 comprises a selectively hardened central region 31' of the moulding 30 over the housing 20 of the light engine 21. This for example can be applied to any device 10 in which the light engine 21 can produce the actinic radiation 41 capable of curing the central region 31 of the moulding 30.

In yet another embodiment, which is schematically depicted in Fig. 6, the housing 20 may comprise a first light engine 21 and a further light engine 22, in which the first light engine 21 produces light having a different spectral composition to the light produced by the further light engine 22. For example, the first light engine 21 may be a UV LED and the further light engine 22 may be a LED adapted to produce a visible light. This LED may be a further UV LED in combination with a phosphor, the phosphor will convert at least a portion of the UV radiation into visible light. Alternatively, the further LED may be a blue LED with a yellow phosphor or any other desired combination of LED and phosphors. In this manner, the first light engine 21 may be used to convert the central region 31 of the moulding into hardened central region 31' whilst the further light engine 22 may be used to produce functional lighting of the device 10. In an embodiment, the first light engine 21 and the further light engine 22 are individually addressable such that the first light engine 21 may be selectively switched on to initiate the aforementioned curing reaction whilst the further light engine 22 may be selectively switched on to provide the functional lighting, such that the functional lighting is not necessarily produced together with the UV light from the first light engine 21. In other words, the first light engine 21 may only be used to initiate the aforementioned curing reaction, after which the further light engine 22 is used to provide the functional lighting of the device 10.It is noted for the avoidance of doubt that where reference is made to the first light engine 21 and the further light engine 22, that this covers embodiments in which the first light engine 21 and the further light engine 22 are individually addressable as well as embodiments in which the first light engine 21 and the further light engine 22 are addressed as a single unit, e.g. a single light engine. For example, the first light engine 21 and the further light engine 22 may be implemented by LEDs, e.g. a first LED and a second LED, which may together form a first light engine or which may form a first light engine and a second light engine. The first LED and the second LED may be located on the same carrier, for example, a printed circuit board (PCB), or they may be located on separate carriers.

As will be understood from the foregoing, the device 10 may take any suitable form, such as the form of an electrical or electronic device. The device 10 may be a domestic appliance such as a refrigerator, freezer, microwave oven, water purifier, dehumidifier, vacuum cleaner, blender, cooker, food processor, mixer, air conditioning unit and so on. The device 10 alternatively may be an electronic device such as a portable computing device, e.g. a smart phone, laptop, personal digital assistant and the like, a computing device such as a personal computer, a computer peripheral device such as a printer, speaker or the like, and so on. The device 10 may be any suitable type of lighting device. The device 10 may be music equipment such as a CD player, amplifier, and so on. The device 10 may be a piece of training equipment such as a fitness apparatus and so on. The device 10 may be a vehicle such as a car, van, lorry, and so on. Many other types of suitable devices 10 will be immediately apparent to the skilled person.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A device (10) comprising:
a housing (20) including a light engine (21), the housing (20) contacting a part (15) of the device (10); and
an elastomer moulding (30) over the housing (20), the elastomer moulding (30) comprising a central region (31') acting as a light exit window for light emitted by the light engine (21) and a peripheral region (33) around the central region (31'), the peripheral region (33) contacting the part (15) and acting as a seal;
wherein the central region (31') is cured and the peripheral region (33) is not cured or cured to a lesser degree than the central region (31') so that the central region (31') has a greater hardness than the peripheral region (33).

2. The device (10) of claim 1, wherein at least part of the light (41) emitted by the light engine (21) has a wavelength capable of curing the central portion (31').

3. The device (10) of claim 2, wherein the light engine (21) comprises a light emitting diode capable of emitting UV radiation.

4. The device (10) of claim 2 or 3, wherein the housing (20) comprises a further light engine (22) capable of emitting visible light.

5. The device (10) of any of claims 1-4, wherein the elastomer moulding comprises a silicone.

6. The device (10) of claim 5, wherein the silicone is polydimethylsiloxane.

7. The device (10) of any of claims 1-6, wherein the device (10) is an electronic device.

8. The device (10) of claim 7, wherein the electronic device is a domestic appliance or a portable electronic device.

9. A method of sealing a device (10) comprising a housing (20) including a light engine (21) , the housing (20) contacting a part (15) of the device (10), the method comprising:
providing an elastomer moulding (30) over the housing (20) such that the elastomer moulding (30) comprises a central region (31) acting as a light exit window for light emitted by the light engine (21) and a peripheral region (33) around the central region (31), the peripheral region (33) contacting the part (15) and acting as a seal; and
selectively curing the central region (30) of the elastomer moulding (30) such that the cured central region (31') has a greater hardness than the uncured peripheral region (33).

10. The method of claim 9, wherein the step of selectively curing comprises selectively irradiating the central region (31) with a light source (40) external to the device (10) through a mask (43).

11. The method of claim 9, wherein the step of selectively curing comprises selectively irradiating the central region (31) with the light engine (21).

12. The method of claim 10 or 11, wherein the step of selectively irradiating the central region (31) comprises selectively irradiating the central region (31) with UV radiation.

13. The method of any of claims 9-12, wherein the elastomer moulding is silicone.

14. The method of claim 13, wherein the silicone is polydimethylsiloxane.

## Patentansprüche

1. Vorrichtung (10), umfassend;
ein Gehäuse (20), das eine Lichtmaschine (21) beinhaltet, wobei das Gehäuse (20) einen Teil (15) der Vorrichtung (10) kontaktiert; und
ein Elastomerformstück (30) über dem Gehäuse (20), wobei das Elastomerformstück (30) einen mittleren Bereich (31'), der als ein Lichtaustrittsfenster für Licht dient, das von der Lichtmaschine (21) ausgestrahlt wird, und einen peripheren Bereich (33) um den mittleren Bereich (31') umfasst, wobei der periphere Bereich (33) den Teil (15) kontaktiert und als eine Dichtung dient;
wobei der mittlere Bereich (31') gehärtet ist und der periphere Bereich (33) nicht gehärtet oder in einem geringeren Ausmaß als der mittlere Bereich (31') gehärtet ist, sodass der mittlere Bereich (31') eine größere Härte als der periphere Bereich (33) aufweist.

2. Vorrichtung (10) nach Anspruch 1, wobei mindestens Teil des Lichts (41), das von der eine Lichtmaschine (21) ausgestrahlt wird, eine Wellenlänge aufweist, die imstande ist, den mittleren Abschnitt (31') zu härten.

3. Vorrichtung (10) nach Anspruch 2, wobei die Lichtmaschine (21) eine Leuchtdiode umfasst, die imstande ist, UV-Strahlung auszustrahlen.

4. Vorrichtung (10) nach Anspruch 2 oder 3, wobei das Gehäuse (20) eine weitere Lichtmaschine (22) umfasst, die imstande ist, sichtbares Licht auszustrahlen.

5. Vorrichtung (10) nach einem der Ansprüche 1-4, wobei das Elastomerformstück ein Silikon umfasst.

6. Vorrichtung (10) nach Anspruch 5, wobei das Silikon Polydimethylsiloxan ist.

7. Vorrichtung (10) nach einem der Ansprüche 1-6, wobei die Vorrichtung (10) eine elektronische Vorrichtung ist.

8. Vorrichtung (10) nach Anspruch 7, wobei die elektronische Vorrichtung ein Haushaltsgerät oder eine tragbare elektronische Vorrichtung ist.

9. Verfahren zum Abdichten einer Vorrichtung (10), die ein Gehäuse (20) umfasst, das eine Lichtmaschine (21) beinhaltet, wobei das Gehäuse (20) einen Teil (15) der Vorrichtung (10) kontaktiert, wobei das Verfahren umfasst:
Bereitstellen eines Elastomerformstücks (30) über dem Gehäuse (20), sodass das Elastomerformstück (30) einen mittleren Bereich (31), der als ein Lichtaustrittsfenster für Licht dient, das von der Lichtmaschine (21) ausgestrahlt wird, und einen peripheren Bereich (33) um den mittleren Bereich (31) umfasst, wobei der periphere Bereich (33) den Teil (15) kontaktiert und als eine Dichtung dient; und
selektives Härten des mittleren Bereichs (30) des Elastomerformstücks (30), sodass der mittlere Bereich (31') eine größere Härte als der periphere Bereich (33) aufweist.

10. Verfahren nach Anspruch 9, wobei der Schritt zum selektiven Härten selektives Bestrahlen des mittleren Bereichs (31) mit einer Lichtquelle (40) extern zu der Vorrichtung (10) durch eine Maske (43) umfasst.

11. Verfahren nach Anspruch 9, wobei der Schritt zum selektiven Härten selektives Bestrahlen des mittleren Bereichs (31) mit einer Lichtmaschine umfasst.

12. Verfahren nach Anspruch 10 oder 11, wobei der Schritt zum selektiven Bestrahlen des mittleren Bereichs (31) selektives Bestrahlen des mittleren Bereichs (31) mit UV-Strahlung umfasst.

13. Verfahren nach einem der Ansprüche 9-12, wobei das Elastomerformstück (30) Silikon ist.

14. Verfahren nach Anspruch 13, wobei das Silikon Polydimethylsiloxan ist.

## Revendications

1. Dispositif (10) comprenant :
un boîtier (20) incluant un moteur lumière (21), le boîtier (20) étant en contact avec une partie (15) du dispositif (10) ; et
un moulage élastomère (30) sur le boîtier (20), le moulage élastomère (30) comprenant une région centrale (31') faisant office de fenêtre de sortie de lumière pour de la lumière émise par le moteur lumière (21) et une région périphérique (33) autour de la région centrale (31'), la région périphérique (33) étant en contact avec la partie (15) et faisant office de joint d'étanchéité ;
dans lequel la région centrale (31') est durcie et la région périphérique (33) n'est pas durcie ou est durcie à un degré moindre que la région centrale (31') de telle sorte que la région centrale (31') présente une dureté supérieure à celle de ladite région périphérique (33).

2. Dispositif (10) selon la revendication 1, dans lequel au moins une partie de la lumière (41) émise par le moteur lumière (21) présente une longueur d'onde capable de durcir la partie centrale (31').

3. Dispositif (10) selon la revendication 2, dans lequel le moteur lumière (21) comprend une diode électroluminescente capable d'émettre un rayonnement UV.

4. Dispositif (10) selon la revendication 2 ou 3, dans lequel le boîtier (20) comprend un moteur lumière supplémentaire (22) capable d'émettre de la lumière visible.

5. Dispositif (10) selon l'une quelconque des revendications 1-4, dans lequel le moulage élastomère comprend un silicone.

6. Dispositif (10) selon la revendication 5, dans lequel le silicone est du polydiméthylsiloxane.

7. Dispositif (10) selon l'une quelconque des revendications 1-6, dans lequel le dispositif (10) est un dispositif électronique.

8. Dispositif (10) selon la revendication 7, dans lequel le dispositif électronique est un appareil domestique ou un dispositif électronique portable.

9. Procédé d'étanchéisation d'un dispositif (10) comprenant un boîtier (20) incluant un moteur lumière (21), le boîtier (20) étant en contact avec une partie (15) du dispositif (10), le procédé comprenant :
la fourniture d'un moulage élastomère (30) sur le boîtier (20) de telle sorte que le moulage élastomère (30) comprenne une région centrale (31) faisant office de fenêtre de sortie de lumière pour de la lumière émise par le moteur lumière (21) et une région périphérique (33) autour de la région centrale (31), la région périphérique (33) étant en contact avec la partie (15) et faisant office de joint d'étanchéité ; et
le durcissement sélectif de la région centrale (30) du moulage élastomère (30) de telle sorte que la région centrale durcie (31') présente une dureté supérieure à celle de la région périphérique non durcie (33).

10. Procédé selon la revendication 9, dans lequel l'étape de durcissement sélectif comprend l'éclairement sélectif de la région centrale (31) avec une source de lumière (40) externe au dispositif (10) au moyen d'un masque (43).

11. Procédé selon la revendication 9, dans lequel l'étape de durcissement sélectif comprend l'éclairage sélectif de la région centrale (31) avec le moteur lumière (21).

12. Procédé selon la revendication 10 ou 11, dans lequel l'étape d'éclairage sélectif de la région centrale (31) comprend l'éclairage sélectif de la région centrale (31) avec un rayonnement UV.

13. Procédé selon l'une quelconque des revendications 9-12, dans lequel le moulage élastomère est du silicone.

14. Procédé selon la revendication 13, dans lequel le silicone est du polydiméthylsiloxane.
